# EUROPEAN PATENT APPLICATION

(11) **EP 1 892 776 A2**
(43) Date of publication of application: **27.02.2008**
(21) Application number: 07253355.7
(22) Date of filing: 24.08.2007
(51) Int. Cl.: H01L 51/52, H01L 51/54

(54) **Organic electronic devices**

(30) Priority: 24.08.2006 US 839914 P
(71) Applicant: E.I. du Pont de Nemours and Company, Wilmington, DE 19898 (US)
(72) Inventor: Chesterfield, Reid John, Wilmington, Delaware 19803 (US)
(74) Representative: Towler, Philip Dean

(57) **Abstract**

There is provided an organic electronic device. The device has an anode, a photoactive layer, and a cathode, and further, between the anode and the photoactive layer are positioned:
a buffer layer;
a first hole transport layer; and
a second hole transport layer.

## Description

### BACKGROUND TO THE INVENTION

### Field of the Disclosure

This disclosure relates in general to organic electronic devices, and in particular, to light emitting diode devices.

### Description of the Related Art

Organic materials have been widely used in electronic devices such as organic thin film transistors (OTFTs), organic light emitting diodes (OLEDs), photovoltaic diodes, and liquid crystal displays. Organic photoactive electronic devices, such as OLEDs that make up OLED displays, typically consist of an anode, a hole transport layer, an emitter layer, an electron transport layer, and a cathode. The hole transport layer is typically a single material that is used to enhance injection from the anode into the host of the emitter layer. The emitter layer usually consists of a dopant and host. Alternatively, the emitter layer can be made using a host that emits light, and thus doesn't require a separate dopant.

It is well known to use organic electroluminescent compounds as the active component in light-emitting diodes. Simple organic molecules, conjugated polymers, and organometallic complexes have been used.

There is a continuing need for materials and structures that improve the properties of OLED devices, including color, lifetime and operating voltage.

### SUMMARY OF THE INVENTION

There is provided an organic electronic device comprising an anode, a photoactive layer, and a cathode, wherein between the anode and the photoactive layer are positioned:
a buffer layer;
a first hole transport layer; and
a second hole transport layer.

There is also provided the above device wherein the buffer layer comprises an electrically conductive polymer and a fluorinated acid polymer.

There is also provided the above device, wherein the first hole transport layer comprises a polymeric hole transport material and the second hole transport layer comprises a vapor-deposited small molecule material.

There is provided an organic electronic device comprising:
an anode;
a photoactive layer comprising a bis(diarylamino)chrysene compound, and
a cathode;
wherein said device has a deep blue emission color.

There is provided an organic electronic device comprising:
an anode;
a buffer layer;
a first hole transport layer;
a second hole transport layer; and
a photoactive layer comprising an anthracene derivative,
wherein said device has a deep blue emission color.

The foregoing general description and the following detailed description are exemplary and explanatory only and are not restrictive of the invention, as defined in the appended claims.

### BRIEF DESCRIPTION OF THE DRAWINGS

Embodiments are illustrated in the accompanying figures to improve understanding of concepts as presented herein.
FIG. 1 is a schematic illustration of one type of organic electronic device.
FIG. 2 is a schematic energy level diagram for (A) a device having a single hole transport layer, and (B) a device having first and second hole transport layers.

Skilled artisans appreciate that objects in the figures are illustrated for simplicity and clarity and have not necessarily been drawn to scale. For example, the dimensions of some of the objects in the figures may be magnified relative to other objects to help to improve understanding of embodiments.

### DETAILED DESCRIPTION OF THE INVENTION

Many aspects and embodiments are disclosed herein and are exemplary and not limiting. After reading this specification, skilled artisans will appreciate that other aspects and embodiments are possible without departing from the scope of the disclosure and claims.

Other features and benefits of any one or more of the embodiments will be apparent from the following detailed description, and from the claims. The detailed description first addresses Definitions and Clarification of Terms followed by Device Structure, the Buffer Layer, the First Hole Transport Layer, the Second Hole Transport Layer, the Photoactive Layer, Other Layers, and finally Examples.

### 1. Definitions and Clarification of Terms

Before addressing details of embodiments described below, some terms are defined or clarified.

As used herein, the term "alkyl" includes both branched and straight-chain saturated aliphatic hydrocarbon groups. Unless otherwise indicated, the term is also intended to include cyclic groups. Examples of alkyl groups include methyl, ethyl, propyl, isopropyl, isobutyl, secbutyl, tertbutyl, pentyl, isopentyl, neopentyl, cyclopentyl, hexyl, cyclohexyl, isohexyl and the like. The term "alkyl" further includes both substituted and unsubstituted hydrocarbon groups. In some embodiments, the alkyl group may be mono-, di- and trisubstituted. One example of a substituted alkyl group is trifluoromethyl. Other substituted alkyl groups are formed from one or more of the substituents described herein. In certain embodiments alkyl groups have 1 to 20 carbon atoms. In other embodiments, the group has 1 to 6 carbon atoms. The term is intended to include heteroalkyl groups. Heteroalkyl groups may have from 1-20 carbon atoms.

The term "aryl" means an aromatic carbocyclic moiety of up to 30 carbon atoms, which may be a single ring (monocyclic) or multiple rings (bicyclic, up to three rings) fused together or linked covalently. Any suitable ring position of the aryl moiety may be covalently linked to the defined chemical structure. Examples of aryl moieties include, but are not limited to, phenyl, 1-naphthyl, 2-naphthyl, dihydronaphthyl, tetrahydronaphthyl, biphenyl, anthryl, phenanthryl, fluorenyl, indanyl, biphenylenyl, acenaphthenyl, acenaphthylenyl, and the like. In some embodiments, aryl groups have 6 to 30 carbon atoms. The term is intended to include heteroaryl groups. Heteroaryl groups may have from 4-30 carbon atoms.

The term "buffer layer' is intended to mean a layer comprising electrically conductive or semiconductive materials and may have one or more functions in an organic electronic device, including but not limited to, planarization of the underlying layer, charge transport and/or charge injection properties, scavenging of impurities such as oxygen or metal ions, and other aspects to facilitate or to improve the performance of the organic electronic device. The term "buffer materials" refers to functional materials in a buffer layer and may be polymers, oligomers, or small molecules.

The term "hole transport" when referring to a layer, material, member, or structure, is intended to mean such layer, material, member, or structure facilitates migration of positive charges through the thickness of such layer, material, member, or structure with relative efficiency and small loss of charge. The abbreviation "HT" is used to refer to hole transport.

The term "photoactive" is intended to mean to any material that exhibits electroluminescence or photosensitivity.

The term "deep blue" is intended to mean a color having a C.I.E. y-coordinate less than 0.1. The CIE (Commission Internationale de l'Eclairage ) system characterizes colors by two color coordinates x and y which specify the point on the chromaticity diagram. The 1931 standard is used. CIE coordinates can be determined using, for example, a spectroradiometer.

The term "polymer" is intended to mean a material having at least one repeating monomeric unit. The term includes homopolymers having only one kind of monomeric unit, and copolymers having two or more different monomeric units. Copolymers are a subset of polymers. In some embodiments, a polymer has at least 5 repeating units.

The term "crosslinkable group" is intended to mean a group than can lead to crosslinking via thermal treatment or exposure to UV or visible radiation.

The term "small molecule," when referring to a compound, is intended to mean a compound which does not have repeating monomeric units. In some embodiments, a small molecule has a molecular weight no greater than approximately 2000 g/mol.

The term "electrically conductive polymer" is intended to mean any polymer or oligomer which is inherently or intrinsically capable of electrical conductivity without the addition of carbon black or conductive metal particles. The conductivity of a conductive polymer composition is measured as the lateral conductivity of films made from the composition, in S/cm.

The term "fluorinated acid polymer" is intended to mean a polymer having acidic groups, where at least some of the hydrogens have been replaced by fluorine. The term "acidic group" refers to a group capable of ionizing to donate a hydrogen ion to a Brønsted base.

The term "layer" is used interchangeably with the term "film" and refers to a coating covering a desired area. The term is not limited by size. The area can be as large as an entire device or as small as a specific functional area such as the actual visual display, or as small as a single sub-pixel. Layers and films can be formed by any conventional deposition technique, including vapor deposition, liquid deposition (continuous and discontinuous techniques), and thermal transfer.

As used herein, the terms "comprises," "comprising," "includes," "including," "has," "having" or any other variation thereof, are intended to cover a non-exclusive inclusion. For example, a process, method, article, or apparatus that comprises a list of elements is not necessarily limited to only those elements but may include other elements not expressly listed or inherent to such process, method, article, or apparatus. Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

Also, use of "a" or "an" are employed to describe elements and components described herein. This is done merely for convenience and to give a general sense of the scope of the invention. This description should be read to include one or at least one and the singular also includes the plural unless it is obvious that it is meant otherwise.

Group numbers corresponding to columns within the Periodic Table of the elements use the "New Notation" convention as seen in the CRC Handbook of Chemistry and Physics, 81st Edition (2000-2001).

Unless otherwise defined, all technical and scientific terms used herein have the same meaning as commonly understood by one of ordinary skill in the art to which this invention belongs. Although methods and materials similar or equivalent to those described herein can be used in the practice or testing of embodiments of the present invention, suitable methods and materials are described below. All publications, patent applications, patents, and other references mentioned herein are incorporated by reference in their entirety, unless a particular passage is cited. In case of conflict, the present specification, including definitions, will control. In addition, the materials, methods, and examples are illustrative only and not intended to be limiting.

Some details regarding specific materials, processing acts, and circuits are conventional and may be found in textbooks and other sources and are otherwise known to ordinarily skilled artisans within the organic light-emitting diode display, photodetector, photovoltaic, and semiconductive member arts. Such details need not be presented herein for a fully enabling disclosure.

### 2. Device Structure

The organic electronic device described herein comprises an anode, a photoactive layer, and a cathode, and additionally between the anode and the photoactive layer are positioned:
a buffer layer;
a first hole transport layer; and
a second hole transport layer,
wherein the composition of the first hole transport layer is different from the composition of the second hole transport layer. The device can be described as having a "bilayer hole transport layer", "bilayer HTL", or "HT bilayer."

In some embodiments, the bilayer HTL results in improved film quality for the photoactive layer. In some embodiments, the bilayer HTL results in improved hole injection into the photoactive layer and consequently improved voltage and lifetime.

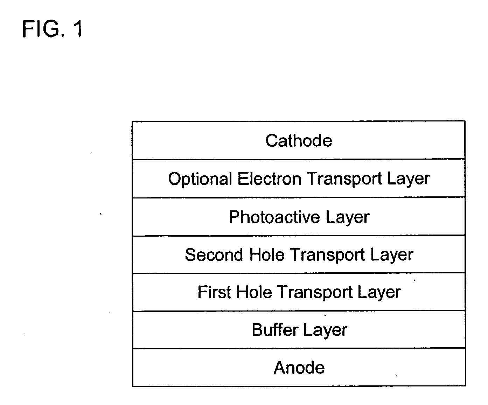

One example of a device is shown in FIG. 1. This device further includes, as an option, an electron transport layer between the photoactive layer and the cathode.

In some embodiments, the first hole transport layer is a polymer and is deposited by liquid deposition. In some embodiments, the first hole transport polymer is designed to be coatable over the buffer layer. For example, if the buffer layer is a layer having a low surface energy, the first hole transport polymer can be optimized to coat such a surface. In some embodiments, the first hole transport layer acts as a planarizing layer to decrease or eliminate shorting that can occur due to asperities in the underlying buffer layer or anode.

In some embodiments, the second hole transport layer acts an an injection enhancer into the photoactive layer, by having optimized energy level alignment, high hole mobility, low electron mobility, and good stability to electron-based conduction.

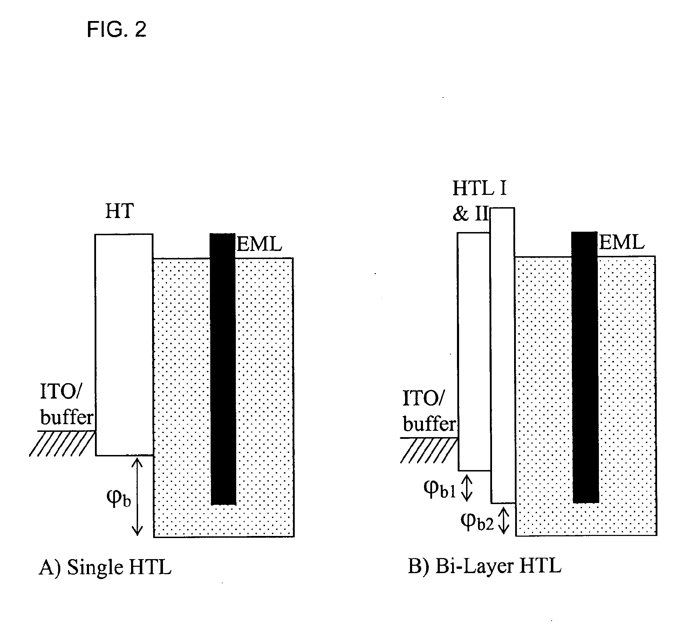

In some embodiments, improved current injection and reduced operating voltage are realized by reducing the injection barrier (ϕ_{b}) for holes to inject into the photoactive layer through better level alignment allowed by the HTL bilayer. FIG. 2 shows a schematic of the energy level alignment in a device with a single HTL (A) and a device with a bilayer HTL (B). The energy level alignment of the bilayer HTL results in the coversion of a single large injection barrier, ϕ_{b} in device A, into two much smaller ones, ϕ_{b1} and ϕ_{b2} in device B.

### 3. Buffer Layer

The buffer layer may be formed with polymeric materials, such as polyaniline (PANI) or polyethylenedioxythiophene (PEDOT), which are often doped with protonic acids. The protonic acids may be, for example, poly(styrenesulfonic acid), poly(2-acrylamido-2-methyl-1-propanesulfonic acid), and the like.

The buffer layer may comprise charge transfer compounds, and the like, such as copper phthalocyanine and the tetrathiafulvalene-tetracyanoquinodimethane system (TTF-TCNQ).

In some embodiments, the buffer layer comprises at least one electrically conductive polymer and at least one fluorinated acid polymer.

In some embodiments, the electrically conductive polymer will form a film which has a conductivity of at least 10⁻⁷ S/cm. The monomer from which the conductive polymer is formed, is referred to as a "precursor monomer". A copolymer will have more than one precursor monomer. In some embodiments, the conductive polymer is made from at least one precursor monomer selected from thiophenes, selenophenes, tellurophenes, pyrroles, anilines, and polycyclic aromatics. The polymers made from these monomers are referred to herein as polythiophenes, poly(selenophenes), poly(tellurophenes), polypyrroles, polyanilines, and polycyclic aromatic polymers, respectively. The term "polycyclic aromatic" refers to compounds having more than one aromatic ring. The rings may be joined by one or more bonds or bridging groups or atoms, or they may be fused together. The term "aromatic ring" is intended to include heteroaromatic rings. A "polycyclic heteroaromatic" compound has at least one heteroaromatic ring. In some embodiments, the polycyclic aromatic polymers are poly(thienothiophenes).

The fluorinated acid polymer may be any polymer which is fluorinated and has acidic groups with acidic protons. The term includes partially and fully fluorinated materials. In some embodiments, the fluorinated acid polymer is highly fluorinated. The term "highly fluorinated" means that at least 50% of the available hydrogens bonded to a carbon have been replaced with fluorine. The acidic groups supply an ionizable proton. In some embodiments, the acidic proton has a pKa of less than 3. In some embodiments, the acidic proton has a pKa of less than 0. In some embodiments, the acidic proton has a pKa of less than -5. The acidic group can be attached directly to the polymer backbone, or it can be attached to side chains on the polymer backbone. Examples of acidic groups include, but are not limited to, carboxylic acid groups, sulfonic acid groups, sulfonimide groups, phosphoric acid groups, phosphonic acid groups, and combinations thereof. The acidic groups can all be the same, or the polymer may have more than one type of acidic group.

In some embodiments the fluorinated acid polymer is water-soluble. In some embodiments, the fluorinated acid polymer is dispersible in water. In some embodiments, the fluorinated acid polymer is organic solvent wettable.

In some embodiments, fluorinated acid polymer has a polymer backbone which is fluorinated. Examples of suitable polymeric backbones include, but are not limited to, polyolefins, polyacrylates, polymethacrylates, polyimides, polyamides, polyaramids, polyacrylamides, polystyrenes, and copolymers thereof. In some embodiments, the polymer backbone is highly fluorinated. In some embodiments, the polymer backbone is fully fluorinated.

In some embodiments, the acidic groups are sulfonic acid groups or sulfonimide groups. A sulfonimide group has the formula:

-SO₂-NH-SO₂-R

where R is an alkyl group.

In some embodiments, the acidic groups are on a fluorinated side chain. In some embodiments, the fluorinated side chains are selected from alkyl groups, alkoxy groups, amido groups, ether groups, and combinations thereof.

In some embodiments, the fluorinated acid polymer has a fluorinated olefin backbone, with pendant fluorinated ether sulfonate, fluorinated ester sulfonate, or fluorinated ether sulfonimide groups. In some embodiments, the polymer is a copolymer of 1,1-difluoroethylene and 2-(1,1-difluoro-2-(trifluoromethyl)allyloxy)-1,1,2,2-tetrafluoroethanesulfonic acid. In some embodiments, the polymer is a copolymer of ethylene and 2-(2-(1,2,2-trifluorovinyloxy)-1,1,2,3,3,3-hexafluoropropoxy)-1,1,2,2-tetrafluoroethanesulfonic acid. These copolymers can be made as the corresponding sulfonyl fluoride polymer and then can be converted to the sulfonic acid form.

In some embodiments, the fluorinated acid polymer is homopolymer or copolymer of a fluorinated and partially sulfonated poly(arylene ether sulfone). The copolymer can be a block copolymer. Examples of comonomers include, but are not limited to butadiene, butylene, isobutylene, styrene, and combinations thereof.

In some embodiments, the buffer layer is made from an aqueous dispersion of an electrically conducting polymer and a colloid-forming polymeric acid. Such materials have been described in, for example, published U.S. patent applications 2004-0102577, 2004-0127637, and 2005-0205860.

In some embodiments, the buffer layer is formed by a solution deposition process. Examples of continuous liquid deposition techniques, include, but are not limited to, spin coating, gravure coating, curtain coating, dip coating, slot-die coating, spray coating, and continuous nozzle coating. Examples of discontinuous liquid deposition techniques include, but are not limited to, ink jet printing, gravure printing, and screen printing.

### 4. First Hole Transport Layer

Examples of hole transport materials for the first hole transport layer have been summarized for example, in Kirk-Othmer Encyclopedia of Chemical Technology, Fourth Edition, Vol. 18, p. 837-860, 1996, by Y. Wang. Both hole transporting small molecules and polymers can be used. Commonly used hole transporting molecules include, but are not limited to: 4,4',4"-tris(N,N-diphenyl-amino)-triphenylamine (TDATA); 4,4',4"-tris(N-3-methylphenyl-N-phenyl-amino)-triphenylamine (MTDATA); N,N'-diphenyl-N,N'-bis(3-methylphenyl)-[1,1'-biphenyl]-4,4'-diamine (TPD); 4, 4'-bis(carbazol-9-yl)biphenyl (CBP); 1,3-bis(carbazol-9-yl)benzene (mCP); 1,1-bis[(di-4-tolylamino) phenyl]cyclohexane (TAPC); N,N'-bis(4-methylphenyl)-N,N'-bis(4-ethylphenyl)-[1,1'-(3,3'-dimethyl)biphenyl]-4,4'-diamine (ETPD); tetrakis-(3-methylphenyl)-N,N,N',N'-2,5-phenylenediamine (PDA); α-phenyl-4-N,N-diphenylaminostyrene (TPS); p-(diethylamino)benzaldehyde diphenylhydrazone (DEH); triphenylamine (TPA); bis[4-(N,N-diethylamino)-2-methylphenyl](4-methylphenyl)methane (MPMP); 1-phenyl-3-[p-(diethylamino)styryl]-5-[p-(diethylamino)phenyl] pyrazoline (PPR or DEASP); 1,2-trans-bis(9H-carbazol-9-yl)cyclobutane (DCZB); N,N,N',N'-tetrakis(4-methylphenyl)-(1,1'-biphenyl)-4,4'-diamine (TTB); N,N'-bis(naphthalen-1-yl)-N,N'-bis-(phenyl)benzidine (α-NPB); and porphyrinic compounds, such as copper phthalocyanine. Commonly used hole transporting polymers include, but are not limited to, polyvinylcarbazole, (phenylmethyl)polysilane, poly(dioxythiophenes), polyanilines, and polypyrroles. It is also possible to obtain hole transporting polymers by doping hole transporting molecules such as those mentioned above into polymers such as polystyrene and polycarbonate.

In some embodiments, the first hole transport layer comprises a hole transport polymer. In some embodiments, the hole transport polymer is a distyrylaryl compound. In some embodiments, the aryl group has two or more fused aromatic rings. In some embodiments, the aryl group is an acene. The term "acene" as used herein refers to a hydrocarbon parent component that contains two or more ortho-fused benzene rings in a straight linear arrangement.

In some embodiments, the hole transport polymer is an arylamine polymer. In some embodiments, it is a copolymer of fluorene and arylamine monomers.

In some embodiments, the polymer has crosslinkable groups. In some embodiments, crosslinking can be accomplished by a heat treatment and/or exposure to UV or visible radiation. Examples of crosslinkable groups include, but are not limited to vinyl, acrylate, perfluorovinylether, 1-benzo-3,4-cyclobutane, siloxane, and methyl esters. Crosslinkable polymers can have advantages in the fabrication of solution-process OLEDs. The application of a soluble polymeric material to form a layer that can be converted into an insoluble film subsequent to deposition, can allow for the fabrication of multilayer solution-processed OLED devices free of layer dissolution problems.

Examples of crosslinkable polymers can be found in, for example, published US patent application 2005-0184287 and published PCT application WO 2005/052027.

In some embodiments, the second hole transport layer comprises a polymer which is a copolymer of 9,9-dialkylfluorene and triphenylamine. In some embodiments, the polymer is a copolymer of 9,9-dialkylfluorene and 4,4'-bis(diphenylamino)biphenyl. In some embodiments, the polymer is a copolymer of 9,9-dialkylfluorene and TPB. In some embodiments, the polymer is a copolymer of 9,9-dialkylfluorene and NPB. In some embodiments, the copolymer is made from a third comonomer selected from (vinylphenyl)diphenylamine and 9,9-distyrylfluorene or 9,9-di(vinylbenzyl)fluorene.

In some embodiments, the second hole transport layer comprises a polymer having Formula I: 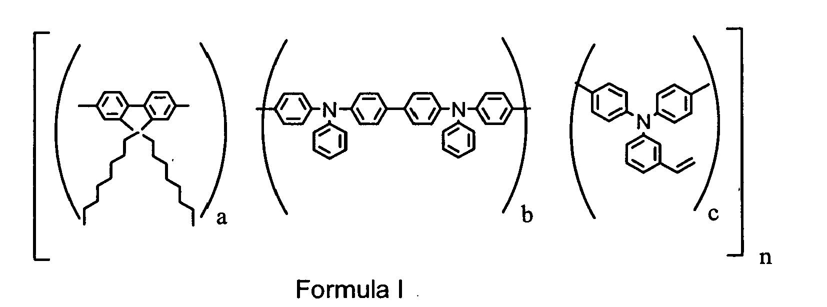 where a, b, and c represent the relative proportion of monomers in the polymer and are non-zero integers; n is a non-zero integer of at least 2. In some embodiments, a, b, and c have values in the range of 1-10. In some embodiments, the ratio a:b:c has the ranges (1-4):(1-4):(1-2). In some embodiments, the ratio a:b:c has the ranges (2-7):(2-7):(1-3). In some embodiments, n is 2-500.

The polymers for the first hole transport layer, in particular, polymers having Formula I, can generally be prepared by three known synthetic routes. In a first synthetic method, as described in Yamamoto, Progress in Polymer Science, Vol. 17, p 1153 (1992), the dihalo or ditriflate derivatives of the monomeric units are reacted with a stoichiometric amount of a zerovalent nickel compound, such as bis(1,5-cyclooctadiene)nickel(0). In the second method, as described in Colon et al., Journal of Polymer Science, Part A, Polymer chemistry Edition, Vol. 28, p. 367 (1990), the dihalo or ditriflate derivatives of the monomeric units are reacted with catalytic amounts of Ni(II) compounds in the presence of stoichiometric amounts of a material capable of reducing the divalent nickel ion to zerovalent nickel. Suitable materials include zinc, magnesium, calcium and lithium. In the third synthetic method, as described in US Patent 5,962,631, and published PCT application WO 00/53565, a dihalo or ditriflate derivative of one monomeric unit is reacted with a derivative of another monomeric unit having two reactive groups selected from boronic acid, boronic acid esters, and boranes, in the presence of a zerovalent palladium catalyst, such as tetrakis(triphenylphosphine)Pd.

In some embodiments, the second hole transport layer comprises a polymer selected from the group consisting of P1 through P5:

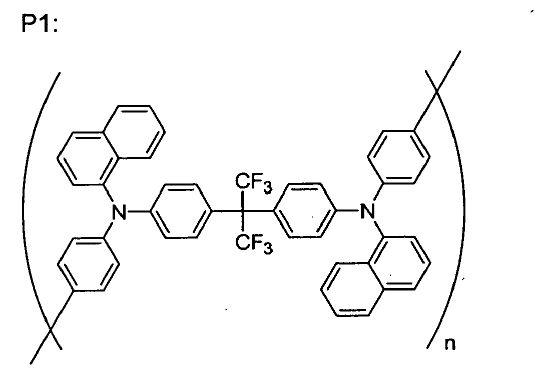

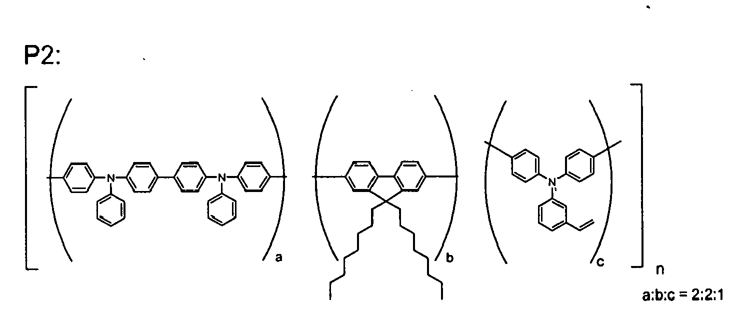

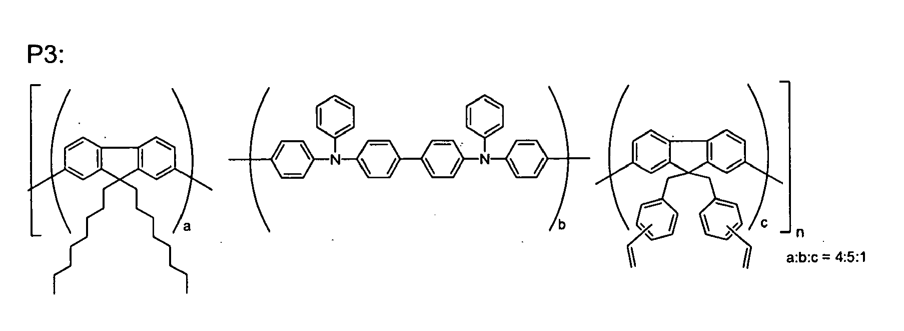

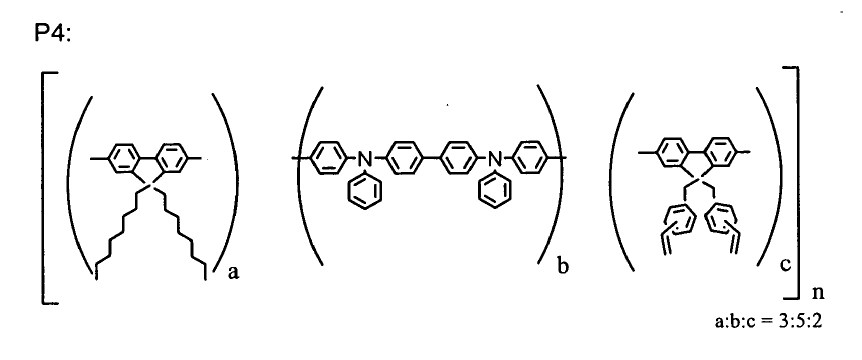

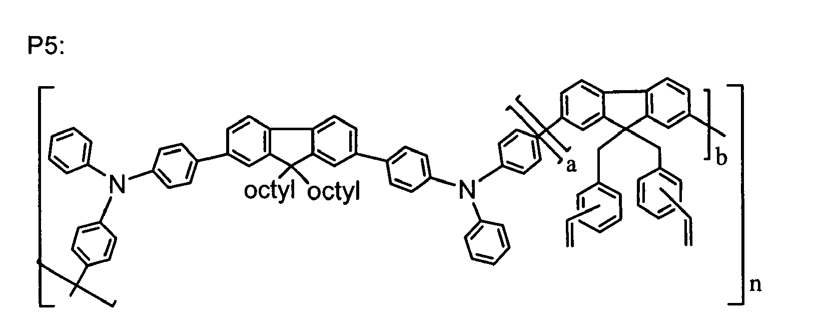

In each of the above formulae P2 to P4, the mole ratios indicated by a, b and c represent preferred values. However, the skilled person would recognise that polymers having small variations from the values indicated will also be effective in the invention. Polymers having such small variations in the mole ratios are also considered to form part of the present invention.

In formula P5, the mole ratio a:b is from 99:1 to 70:30, preferably from 90:10 to 80:20, more preferably about 85:15.

In some embodiments, the first hole transport layer is formed by a solution deposition process, as discussed above.

### 5. Second Hole Transport Layer

Any hole transport material, as discussed above, can be used for the second hole transport layer.

In some embodiments, the second hole transport material is a small molecule. In some embodiments, the small molecule hole transport material has triarylamine groups, for example, NPB, TPD, CBP, MTDATA, and mCP.

In some embodiments, the second hole transport material is selected from:

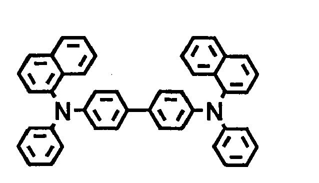

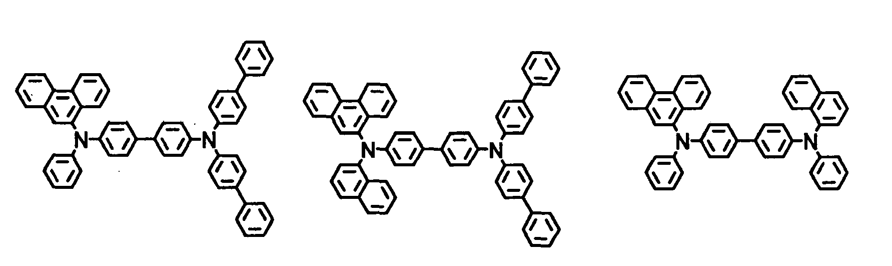

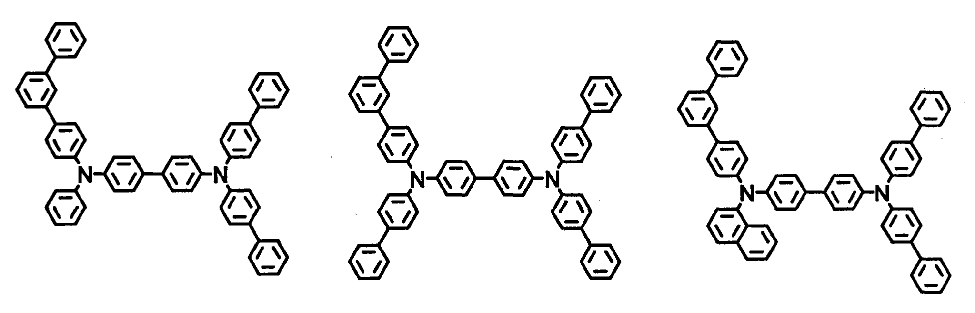

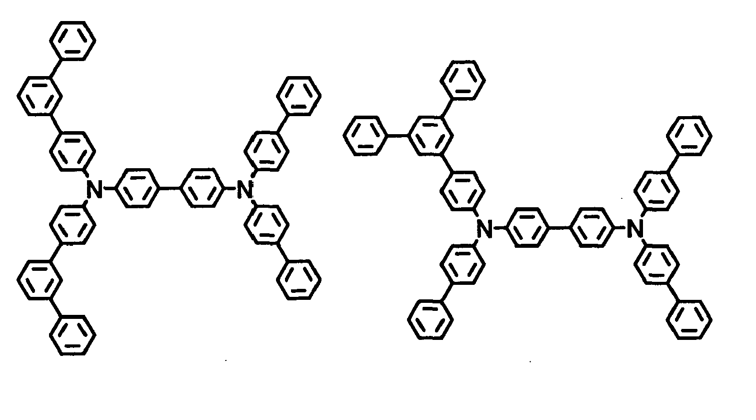

In some embodiments, the second hole transport material is applied by a vapor deposition process. In some embodiments, the material is applied by evaporation under vacuum.

### 6. Photoactive Materials

In some embodiments, the photoactive materials are electroluminescent and are selected from materials which have red, green and blue emission colors. Electroluminescent materials include small molecule organic fluorescent compounds, fluorescent and phosphorescent metal complexes, conjugated polymers, and mixtures thereof. Examples of fluorescent compounds include, but are not limited to, pyrene, perylene, rubrene, coumarin, derivatives thereof, and mixtures thereof. Examples of metal complexes include, but are not limited to, metal chelated oxinoid compounds, such as tris(8-hydroxyquinolato)aluminum (Alq3); cyclometalated iridium and platinum electroluminescent compounds, such as complexes of iridium with phenylpyridine, phenylquinoline, or phenylpyrimidine ligands as disclosed in Petrov et al., U.S. Patent 6,670,645 and Published PCT Applications WO 03/063555 and WO 2004/016710, and organometallic complexes described in, for example, Published PCT Applications WO 03/008424, WO 03/091688, and WO 03/040257, and mixtures thereof. Electroluminescent emissive layers comprising a charge carrying host material and a metal complex have been described by Thompson et al., in U.S. Patent 6,303,238, and by Burrows and Thompson in published PCT applications WO 00/70655 and WO 01/41512. Examples of conjugated polymers include, but are not limited to poly(phenylenevinylenes), polyfluorenes, poly(spirobifluorenes), polythiophenes, poly(p-phenylenes), copolymers thereof, and mixtures thereof.

In some embodiments, the EL material is present with a host material. In some embodiments, the host is a charge carrying material. In an EL/host system, the EL material can be a small molecule or polymer and the host can be independently a small molecule or polymer.

In some embodiments, the EL material is a cyclometalated complex of iridium. In some embodiments, the complex has two ligands selected from phenylpyridines, phenylquinolines, and phenylisoquinolines, and a third ligand with is a β-dienolate. The ligands may be unsubstituted or substituted with F, D, alkyl, CN, or aryl groups.

In some embodiments, the EL material is a polymer selected from the group consisting of poly(phenylenevinylenes), polyfluorenes, and polyspirobifluorenes.

In some embodiments, the EL material is selected from the group consisting of a non-polymeric spirobifluorene compound and a fluoranthene compound.

In some embodiments, the EL material is a compound having aryl amine groups. In some embodiments, the EL material is selected from the formulae below: 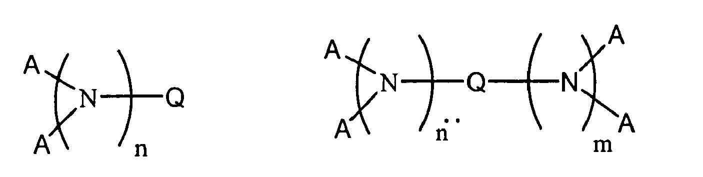 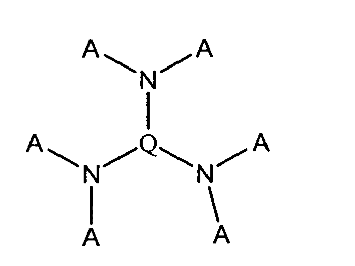 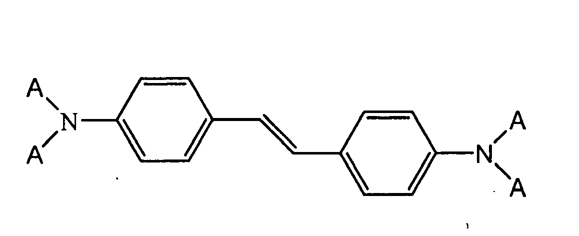 where:
A is the same or different at each occurrence and is an aromatic group having from 3-60 carbon atoms;
Q is a single bond or an aromatic group having from 3-60 carbon atoms;
n and m are independently an integer from 1-6.

In some embodiments of the above formula, at least one of A and Q in each formula has at least three condensed rings. In some embodiments, m and n are equal to 1. In some embodiments, Q is a styryl or styrylphenyl group.

In some embodiments, the EL material has the formula below: 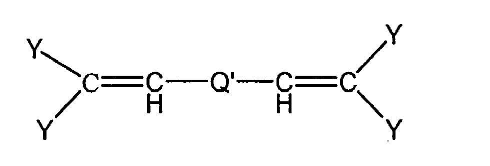 where:
Y is the same or different at each occurrence and is an aromatic group having 3-60 carbon atoms;
Q' is an aromatic group, a divalent triphenylamine residue group, or a single bond.

In some embodiments, the EL material is an aryl acene. In some embodiments, the EL material is an non-symmetrical aryl acene.

In some embodiments, the EL material is a chrysene derivative. The term "chrysene" is intended to mean 1,2-benzophenanthrene. In some embodiments, the EL material is a chrysene having aryl substituents. In some embodiments, the EL material is a chrysene having arylamino substituents. In some embodiments, the EL material is a chrysene having two different arylamino substituents. In some embodiments, the chrysene derivative has a deep blue emission.

In some embodiments, the EL material is selected from the group consisting of: 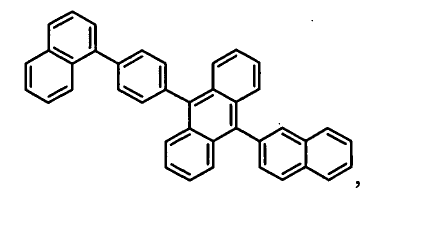 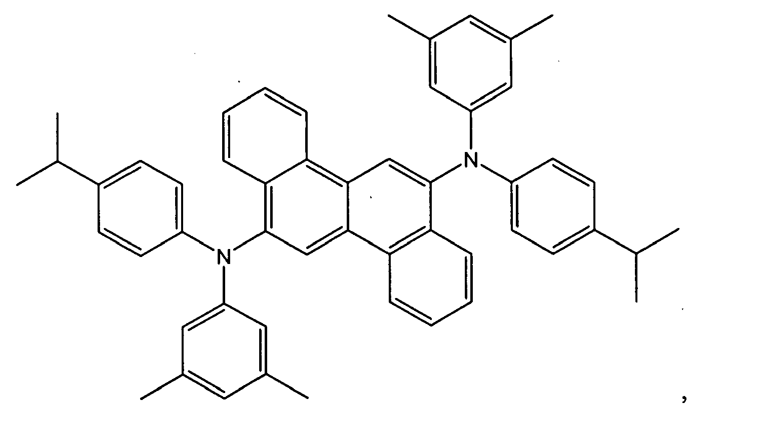 and mixtures thereof.

In some embodiments, the host is a bis-condensed cyclic aromatic compound

In some embodiments, the host is an anthracene derivative compound. In some embodiments the compound has the formula:

An - L-An

where:
An is an anthracene moiety;
L is a divalent connecting group.
In some embodiments of this formula, L is a single bond, -O-, -S-, -N(R)-, or an aromatic group. In some embodiments, An is a mono- or diphenylanthryl moiety.

In some embodiments, the host has the formula:

A-An-A

where:
An is an anthracene moiety;
A is an aromatic group.

In some embodiments, the host is an anthracene derivative with the formula: 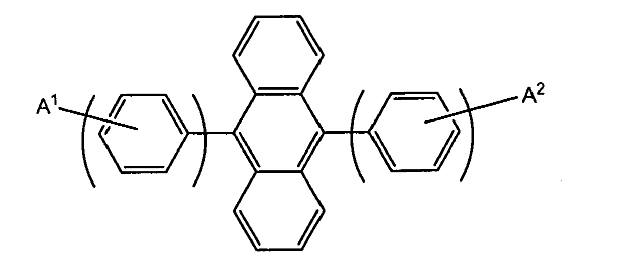 where:
A¹ and A² are the same or different at each occurrence and are selected from the group consisting of H, an aromatic group comprising a single ring or a plurality of fused rings, and an alkenyl group; and
each of the phenyl groups in brackets may independently be instead a biphenyl or triphenyl group.
In some embodiments, the anthracene derivative is non-symmetrical. In some embodiments, one of the bracketed rings is phenyl and the other is biphenyl. In some embodiments, at least one of A¹ and A² is a naphthyl group.

In some cases, the host material is also emissive and can be used alone as the emitter in a photoactive layer. In some embodiments, the host can be used in combination with another host as the emitter in a photoactive layer.

### 7. Other Layers

The other layers in the device can be made of any materials that are known to be useful in such layers. The anode is an electrode that is particularly efficient for injecting positive charge carriers. It can be made of, for example, materials containing a metal, mixed metal, alloy, metal oxide or mixed-metal oxide, or it can be a conducting polymer, and mixtures thereof. Suitable metals include the Group 11 metals, the metals in Groups 4, 5, and 6, and the Group 8-10 transition metals. If the anode is to be light-transmitting, mixed-metal oxides of Groups 12, 13 and 14 metals, such as indium-tin-oxide, are generally used. The anode may also comprise an organic material such as polyaniline as described in "Flexible light-emitting diodes made from soluble conducting polymer," Nature, vol. 357, pp 477 479 (11 June 1992). At least one of the anode and cathode should be at least partially transparent to allow the generated light to be observed.

Examples of electron transport materials which can be used in the optional electron transport layer 140, include metal chelated oxinoid compounds, such as tris(8-hydroxyquinolato)aluminum (Alq3) and tetrakis-(8-hydroxyquinolato)zirconium (Zrq4); and azole compounds such as 2- (4-biphenylyl)-5-(4-t-butylphenyl)-1,3,4-oxadiazole (PBD), 3-(4-biphenylyl)-4-phenyl-5-(4-t-butylphenyl)-1,2,4-triazole (TAZ), and 1,3,5-tri(phenyl-2-benzimidazole)benzene (TPBI); quinoxaline derivatives such as 2,3-bis(4-fluorophenyl)quinoxaline; phenanthrolines such as 4,7-diphenyl-1,10-phenanthroline (DPA) and 2,9-dimethyl-4,7-diphenyl-1,10-phenanthroline (DDPA); and mixtures thereof.

The cathode is an electrode that is particularly efficient for injecting electrons or negative charge carriers. The cathode can be any metal or nonmetal having a lower work function than the anode. Materials for the cathode can be selected from alkali metals of Group 1 (e.g., Li, Cs), the Group 2 (alkaline earth) metals, the Group 12 metals, including the rare earth elements and lanthanides, and the actinides. Materials such as aluminum, indium, calcium, barium, samarium and magnesium, as well as combinations, can be used. Li-containing organometallic compounds, LiF, and Li₂O can also be deposited between the organic layer and the cathode layer to lower the operating voltage. This layer may be referred to as an electron injection layer.

In some embodiments, the different layers have the following range of thicknesses (in Angstroms): anode, 500-5000 A, preferably 1000-2000 A; first hole transport layer, 50-2000 A, preferably 100-1000 A; second hole transport layer, 10-2000 A, preferably, 50-200 A; photoactive layer, 10-2000 A, preferably 100-1000 A; optional electron transport layer, 50-2000 A, preferably 100-1000 A; cathode, 200-10000 A, preferably 300-5000 A. The location of the electron-hole recombination zone in the device, and thus the emission spectrum of the device, can be affected by the relative thickness of each layer. Thus the thickness of the electron-transport layer should be chosen so that the electron-hole recombination zone is in the light-emitting layer. The desired ratio of layer thicknesses will depend on the exact nature of the materials used.

In some embodiments, the device has the following structure, in order: anode, buffer layer, first hole transport layer, second hole transport layer, photoactive layer, electron transport layer, electron injection layer, cathode.

In some embodiments, the device is fabricated by liquid deposition of the buffer layer, the first hole transport layer, and the photoactive layer, and by vapor deposition of the second hole transport layer, the electron transport layer, the electron injection layer, and the cathode.

In some embodiments, the device is fabricated by liquid deposition of the buffer layer and the first hole transport layer, and by vapor deposition of the second hole transport layer, the photoactive layer, the electron transport layer, the electron injection layer, and the cathode.

### EXAMPLES

The concepts described herein will be further described in the following examples, which do not limit the scope of the subject matter described in the claims.

### Example 1

Example 1 demonstrates the preparation of Polymer P2. 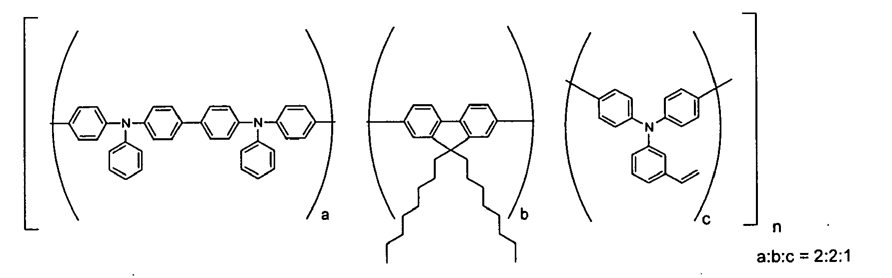 Bis(1,5-Cyclooctadiene)-nickel-(0) (1.667 g, 6.06 mmol ) was added to a N,N-dimethylformamide (anhydrous, 6 mL) solution of 2,2'-bipyridyl (0.946 g, 6.06 mmol) and 1,5-cyclooctadiene (0.656 g, 6.06 mmol). The resulting mixture was heated to 60°C for 30 min. A toluene (anhydrous, 25 mL) solution of 9,9-dioctyl-2,7-dibromofluorene (0.658 g, 1.20 mmol), N,N'-Bis(4-bromomphenyl)-N,N'-diphenylbenzidine (0.776g, 1.20 mmol) and N,N-Bis(4-chlorophenyl)-3-vinylaniline (0.204 g, 0.60 mmol) was then added rapidly to the stirring catalyst mixture. The mixture was stirred at 60°C for ten hours. After the reaction mixture cooled to room temperature, it was poured, slowly, with vigorous stirring into 500 mL methanol and stirred overnight. Addition of 20mL of conc. HCI followed and the mixture was stirred for an hour. The precipitate was filtered and then added to 125 mL of toluene and poured slowly into 1 L of 1:1 methanol:acetone solution which contained 25 mL conc. HCl. The resulting yellow precipitate was stirred for 30 min and then isolated by filtration. The solid was further purified by chromatography (silica, toluene) and precipitation from ethyl acetate. After drying the resulting material under vacuum a light yellow polymer was isolated in 80% yield (0.97 g). GPC (THF, room temperature): Mn = 60,616; Mw = 365,589; Mw/Mn = 5.98.

Polymers P3 and P4 were made in an analogous manner using 2,7-dibromo-9,9'-(p-vinylbenzyl)-fluorene in place of the bis(4-chlorophenyl)-3-vinylaniline, and the appropriate ratios of reactants.

### Example 2

Example 2 illustrates the formation of an organic light-emitting diode ("OLED") using a bilayer HTL.

OLED devices were fabricated by a combination of solution processing and thermal evaporation techniques. A glass substrate with 50 nm indium tin oxide was used as the anode. The substrate was patterned and cleaned under UV-ozone.

Immediately before device fabrication the cleaned, patterned ITO substrates were treated with UV-ozone for 10 minutes. Immediately after cooling, an aqueous dispersion of Buffer 1 was spin-coated over the ITO surface and heated to remove solvent. The substrates were then baked and transferred to a drybox, in which all further manipulations were conducted. To form the first hole transport layer, after cooling, the substrates were spin-coated with a 0.4% w/v solution of hole transport polymer P3 in toluene, and then heated to remove solvent and effect crosslinking, resulting in a 20 nm thick layer. The substrates were then masked and placed in a vacuum chamber. A second hole transport layer was then formed by evaporating a layer of NPB, to form a 6 nm layer. To form the photoactive layer, a 13:1 w/w mixture of Emitter 2:Emitter 1 was co-evaporated to a thickness of 39 nm. In this layer, Emitter 2 acted as a host.

A 20 nm layer of AIQ was deposited by thermal evaporation to form an electron transport layer. This was followed by a 1 nm layer of lithium fluoride. A 100 nm overcoat of Al was vapor deposited, to form the cathode. The devices were encapsulated using a glass lid, getter pack, and UV curable epoxy.

The OLED samples were characterized by measuring their (1) current-voltage (I-V) curves, (2) electroluminescence radiance versus voltage, and (3) electroluminescence spectra versus voltage. All three measurements were performed at the same time and controlled by a computer. The current efficiency of the device at a certain voltage is determined by dividing the electroluminescence radiance of the LED by the current density needed to run the device. The unit is cd/A. The power efficiency is the current efficiency divided by the operating voltage. The unit is lm/W.

The materials used in device fabrication are listed below and the results are given in Table 1:

### Buffer 1:

An aqueous dispersion of polypyrrole and a polymeric fluorinated sulfonic acid. The material was prepared using a procedure similar to that described in Example 1 of published U.S. patent application no. 2005/0205860.

### NPB:

### N, N'-Bis(naphthalen-1-yl)-N, N'-bis-(phenyl)benzid ine

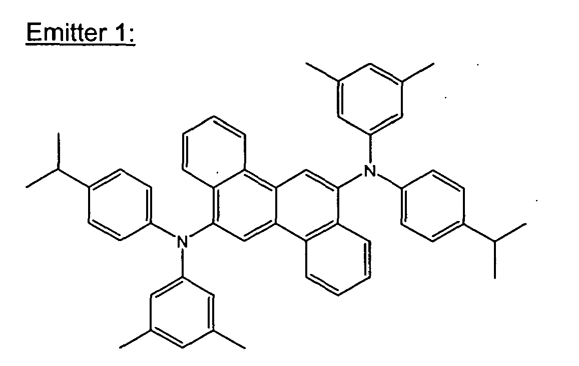

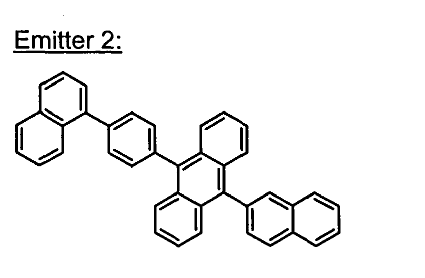

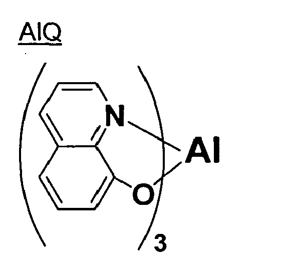

### Example 3

Example 3 illustrates the formation of an organic light-emitting diode ("OLED") using a bilayer HTL.

An OLED was prepared according to the procedure described in Example 2, using the following materials:
buffer layer = Buffer 1
first hole transport layer = hole transport polymer P4
second hole transport layer = NPB
photoactive layer = 13:1 Host 1: Dopant 1
electron transport layer = AIQ
electron injection layer = LiF
cathode = Al
Host 1 and Dopant 1 are supplied by Idemitsu Kosan Co. (Chiba, Japan), as a blue host and dopant.

The device characterization data is summarized in Table 1.

### Comparative Example A

This comparative example demonstrates an OLED made with a single polymeric hole transport layer.

The device was made using the procedure and materials of Example 3, except that the second hole transport layer was omitted. The single hole transport layer was polymer P4.

The device characterization data is summarized in Table 1.

### Comparative Example B

This comparative example demonstrates an OLED made with a single small molecule hole transport layer.

The device was made using the procedure and materials of Example 3, except that the first hole transport layer was omitted. The single hole transport layer was vapor deposited NPB.

The device characterization data is summarized in Table 1.

**Table 1 Device Data**

| Example | HTL | Efficiency, cd/A (@ 1000 nits) | Lifetime, hrs (@ Lum, nits) projected | Color coord. (x, y) |
|---|---|---|---|---|
| 2 | P3/NPB | 7.3 | 4600 (2000) | 0.134, |
| | | | | 0.156 |
| 3 | P4/NPB | 8.1 | 8000 (2000) | 0.134, |
| | | | | 0.157 |
| Comp. A | P4 | 5.7 | 140 (2660) | 0.138, |
| | | | | 0.138 |
| Comp. B | NPB | 7.2 | 6000 (2000) | 0.136, |
| | | | | 0.138 |

### Example 4

This example demonstrates an OLED having deep blue emission.

An OLED was fabricated using the procedure and materials of Example 2, except that the photoactive layer was a 34 nm thick layer of Emitter 2 only.

This device had an efficiency of 1.6 cd/A at 700 nits, and a lifetime (projected) of 3500 hours at 700 nits. The color coordinates were x=0.152 and y=0.076.

Note that not all of the activities described above in the general description or the examples are required, that a portion of a specific activity may not be required, and that one or more further activities may be performed in addition to those described. Still further, the order in which activities are listed are not necessarily the order in which they are performed.

In the foregoing specification, the concepts have been described with reference to specific embodiments. However, one of ordinary skill in the art appreciates that various modifications and changes can be made without departing from the scope of the invention as set forth in the claims below. Accordingly, the specification and figures are to be regarded in an illustrative rather than a restrictive sense, and all such modifications are intended to be included within the scope of invention.

Benefits, other advantages, and solutions to problems have been described above with regard to specific embodiments. However, the benefits, advantages, solutions to problems, and any feature(s) that may cause any benefit, advantage, or solution to occur or become more pronounced are not to be construed as a critical, required, or essential feature of any or all the claims.

It is to be appreciated that certain features that are, for clarity, described herein in the context of separate embodiments, may also be provided in combination in a single embodiment. Conversely, various features that are, for brevity, described in the context of a single embodiment, may also be provided separately or in any subcombination. Further, references to values stated in ranges include each and every value within that range.

## Claims

1. An organic electronic device comprising an anode, a photoactive layer, and a cathode, wherein between the anode and the photoactive layer are positioned:
a buffer layer;
a first hole transport layer; and
a second hole transport layer.

2. A device of Claim 1, wherein the buffer layer comprises an electrically conductive polymer and a fluorinated acid polymer.

3. A device of Claim 1 or Claim 2, wherein the first hole transport layer comprises a polymeric hole transport material.

4. A device of Claim 3 wherein the polymeric hole transport material comprises a distyrylaryl compound.

5. A device of Claim 4 wherein the aryl group of the distyrylaryl compound is an acene.

6. A device of Claim 3 wherein the polymeric hole transport material comprises a material selected from the group consisting of (i) arylamines and (ii) copolymers comprising fluorene and arylamine monomers.

7. A device of any of Claims 3 to 6 wherein the polymeric hole transport material comprises crosslinkable groups.

8. A device of any of Claims 1 to 7, wherein the second hole transport layer comprises a vapor-deposited small molecule material.

9. A device of any of Claims 1 to 8, wherein the second hole transport layer comprises a small molecule material selected from the following:

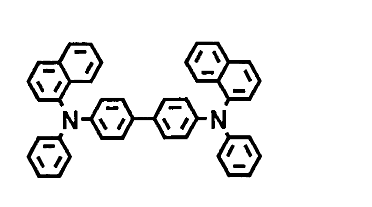

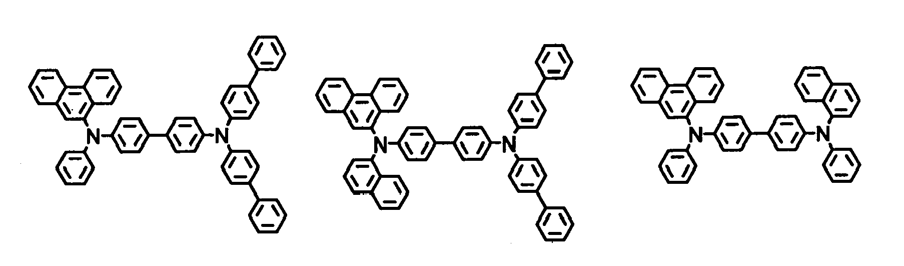

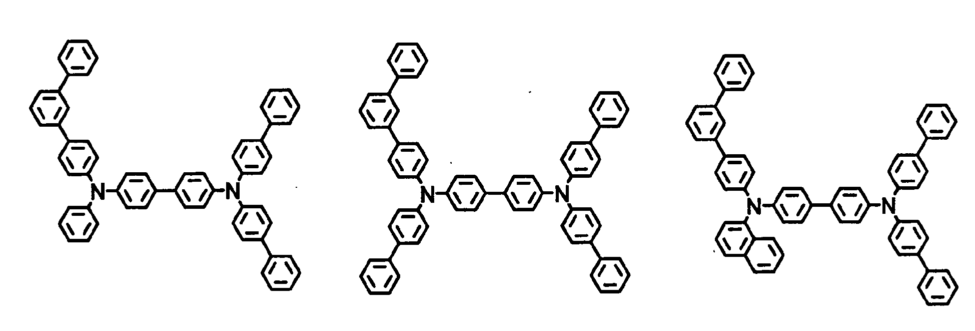

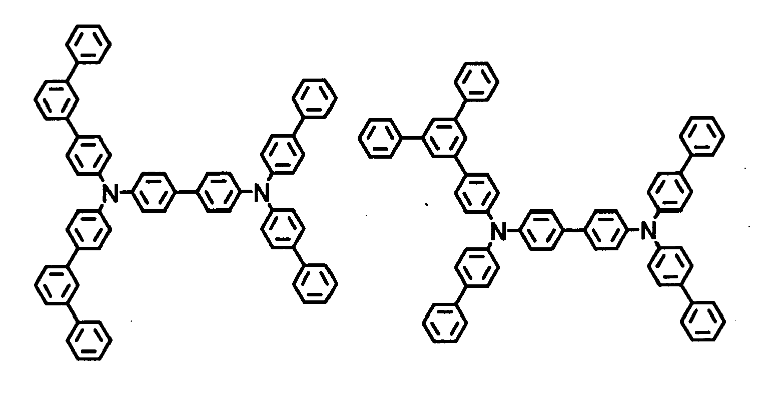

10. A device of any of Claims 1 to 9, wherein the second hole transport layer comprises a polymer.

11. A device of Claim 10 wherein the polymer is a copolymer of 9,9-dialkylfluorene monomers and monomers selected from triphenylamine, 4,4'-bis(diphenylamino)biphenyl, TPB, and NPB.

12. A device of Claim 11 wherein the polymer comprises a third monomer comprising a comonomer selected from (vinylphenyl)diphenylamine and 9,9-distyrylfluorene or 9,9-di(vinylbenzyl)fluorene.

13. A device of Claim 10 wherein the second hole transport layer comprises a polymer having Formula I: 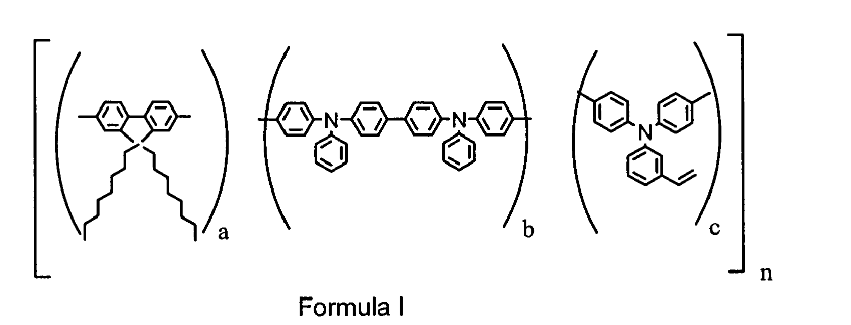 where a, b, and c represent the relative proportion of monomers in the polymer and are non-zero integers; n is an integer of at least 2.

14. A device of Claim 13 wherein a, b, and c have values in the range of 1-10.

15. A device of Claim 13 wherein the ratio a:b:c has the ranges (1-4):(1-4):(1-2), and n has a value in the range of 2-500.

16. A device of Claim 13 wherein the ratio a:b:c has the ranges (2-7):(2-7):(1-3), and n has a value in the range of 2-500.

17. A device of Claim 10 wherein the second hole transport layer comprises a material having Formula P1 through P5: 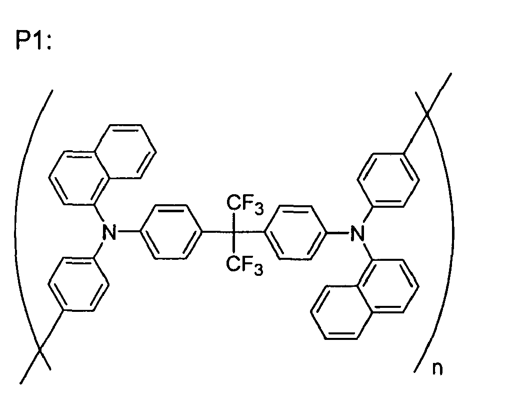 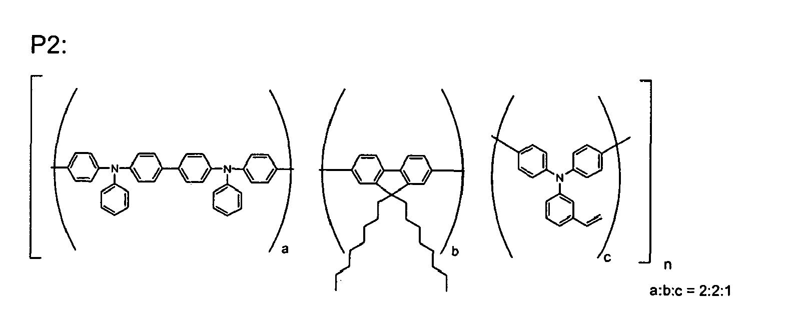 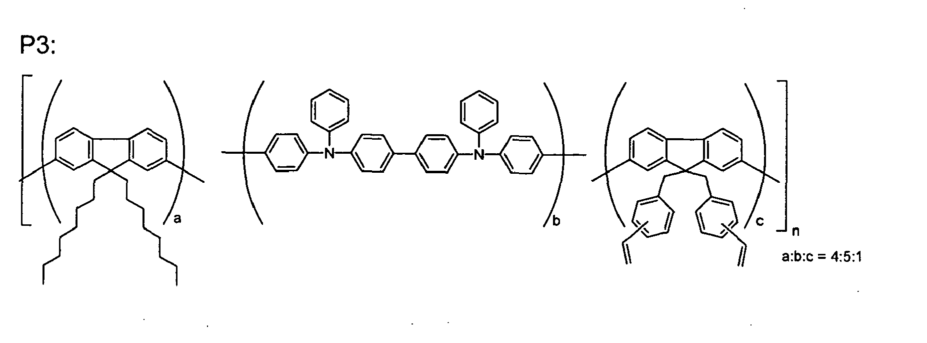 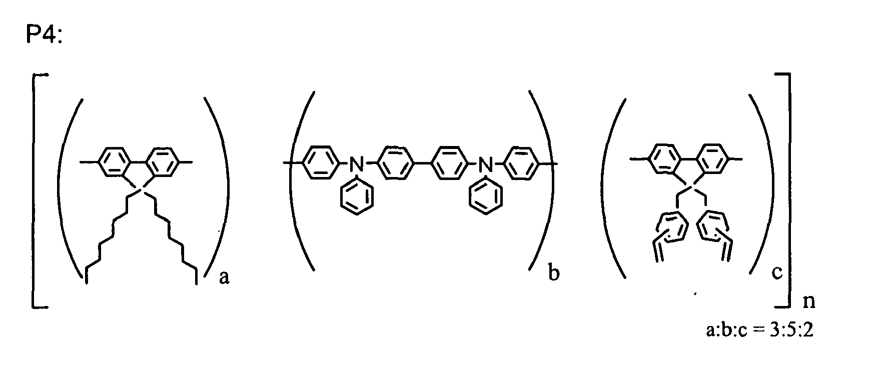 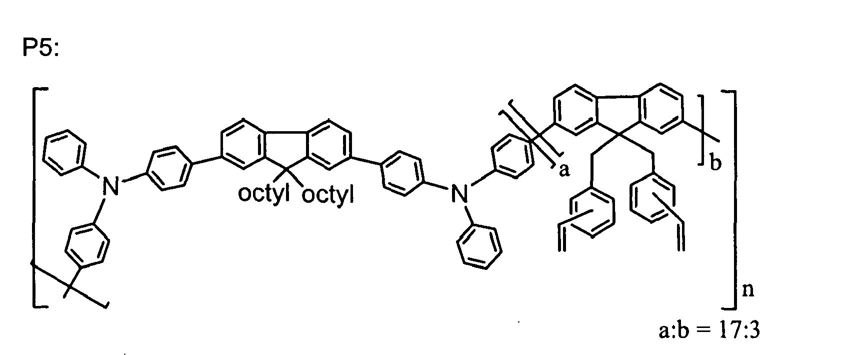 where a, b, and c represent the relative proportion of monomers in the polymer and are non-zero integers; n is an integer of at least 2.

18. An organic electronic device comprising:
an anode;
a photoactive layer, and
a cathode;
wherein the photoactive layer comprises an anthracene derivative.

19. A device of Claim 18 wherein the anthracene derivative has the formula: 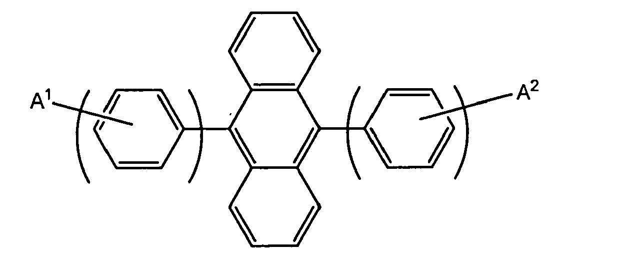 where:
A¹ and A² are the same or different at each occurrence and are selected from the group consisting of H, an aromatic group comprising a single ring or a plurality of fused rings, and an alkenyl group; and
each of the phenyl groups in brackets may independently be instead a biphenyl or triphenyl group.

20. A device of Claim 19 wherein said device has a deep blue emission color.

21. An organic electronic device comprising:
an anode;
a buffer layer;
a first hole transport layer;
a second hole transport layer; and
a photoactive layer, and
wherein the photoactive layer comprises a bis(diarylamino)chrysene derivative.

22. The device of claim 21 wherein the bis(diarylamino)chrysene has the formula:

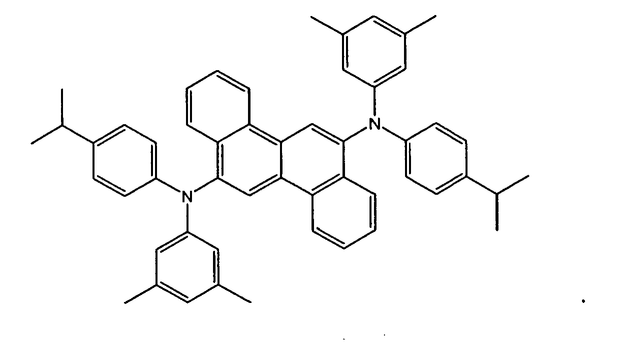

23. A device of Claim 21 wherein said device has a deep blue emission color.
